# EUROPEAN PATENT APPLICATION

(11) **EP 0 905 760 A2**
(43) Date of publication of application: **31.03.1999**
(21) Application number: 98117728.0
(22) Date of filing: 18.09.1998
(51) Int. Cl.: H01L 21/334, H01L 29/94

(54) **Integrated MOS capacitor fabrication method and structure**

(30) Priority: 30.09.1997 US 941094
(71) Applicant: SIEMENS AKTIENGESELLSCHAFT, 80333 München (DE)
(72) Inventor: Schrems, Martin, 01465 Langenbrueck (DE)
(74) Representative: Patentanwälte Westphal, Mussgnug & Partner

(57) **Abstract**

A method for forming a dielectric for a capacitor. The method includes providing a semiconductor; forming a non-uniform layer on a surface of the semiconductor; subjecting the semiconductor and the non-uniform layer thereon to heat and pressure producing pits in a surface of the semiconductor; forming a second dielectric over the pitted surface of the semiconductor to provide the dielectric for the capacitor. With such method, the dielectric has increased surface area for formation of a capacitor electrode having a corresponding increased surface area to thereby increase the capacitance of the capacitor. Thus, the usually detrimental effect of pit formation is used to increase the surface area of the electrodes of a capacitor. The step of subjecting the semiconductor to heat and pressure producing pits in a surface of the semiconductor comprises the step of subjecting the semiconductor with the dielectric layer thereon to a first anneal and wherein the step of rounding the pits produced in the surface of the semiconductor comprises the step of subjecting the semiconductor to a second anneal. A DRAM cell is provided having a single crystal body. The body has formed therein a transistor and a capacitor coupled to the capacitor. The capacitor includes a doped single crystal semiconductor portion formed in the body, such portion having a pitted surface. The doped semiconductor portion provides a first electrode for the capacitor. A dielectric is disposed over the pitted surface of the semiconductor. A second electrode for the capacitor is disposed over the dielectric and electrically is connected to the transistor.

## Description

### Background of the Invention

This invention relates generally to integrated circuits and more particularly to methods used in forming capacitors used in integrated circuits.

As is known in the art, one type of integrated circuit which uses a capacitor is a dynamic random access memory (DRAM) cell. Such cell includes a capacitor to store charge, or not store charge, to thereby represent either a logic 1 or logic 0 condition, and a transistor to address the capacitor. As is also known in the art, with increased integration density, space available for both transistor and capacitor used in the cell are continually being reduced. However, the amount of charge stored in the capacitor should be as large as possible in order to ensure good data retention time. The capacitance may be increased by reducing the thickness of the dielectric used between the pair of conductive electrode (i.e., plates) of the capacitor, increasing the dielectric constant of the dielectric, and/or increasing the surface area of the electrodes. The amount of reduction of the dielectric thickness is limited by a corresponding increase of leakage current, i.e., by direct tunneling of electrons through the dielectric which degrades retention time. Increasing the dielectric constant requires changing the dielectric material however such may not be readily compatible with other processes required in the DRAM process.

With regard to increasing the area of the capacitor electrode, several techniques have been suggested; however a significant number of additional process steps are required, some of which may not compatible with other required processing steps. One technique suggested is described in an article entitled "An Advanced Technique for Fabricating Hemispherical-Grained (HSG) Silicon Storage Electrodes" by Watanabe et al, IEEE Transactions on Electron Devices", Vol. 42, No. 2, February 1995 pages 295-300. Such paper describes forming DRAM capacitor plate with an even-surface amorphous-silicon and then changing it to one with an uneven-surface hemispherical-grained silicon (Si). The method consists of the formation of a smooth amorphous silicon plate (i.e., electrode) by low-pressure chemical vapor deposition followed by removal of native oxide and high-vacuum annealing. The annealing process forms HSG-Si covering the entire surface of all types of storage electrodes, including side-wall surfaces which had previously been dry-etched. Another technique is described in U.S.Patent No. 5,324,769. Such patent describes formation of the conductor as an uneven structure by forming a polycrystalline silicon pattern on a semiconductor substrate. An insulating film having pin holes is formed on the surface of the polycrystalline pattern. The polycrystalline silicon pattern is then etched through the pin holes. Next, the insulating film is removed. Still another technique is described in an article entitled "Growth of Polycrystalline Silicon Grains" by Matsuo et al, Japanese Journal of Applied Physics, Vol. 35 (1996) pp. L-1215-1218, Part 2, No. 9B, September 1996. The article describes the formation of dome-shaped grains. An amorphous silicon (a-Si) film was deposited by vertical LPCVD onto an oxide layer which was formed on a Si substrate. Deposition of the a-Si film was followed by in situ annealing carried out at the same temperature as the deposition.

### Summary of the Invention

In accordance with the invention, a method is provided for forming a dielectric for a capacitor. The method includes providing a semiconductor; forming a non-uniform layer on a surface of the semiconductor; subjecting the semiconductor and the non-uniform layer thereon to heat and pressure producing pits in a surface of the semiconductor; forming a second dielectric over the pitted surface of the semiconductor to provide the dielectric for the capacitor.

With such method, the dielectric has increased surface area for formation of a capacitor electrode having a corresponding increased surface area to thereby increase the capacitance of the capacitor. Thus, the usually detrimental effect of pit formation is used to increase the surface area of the electrodes of a capacitor.

In accordance with another feature of the invention, a capacitor is provided having a doped single crystal semiconductor with a pitted surface. The doped semiconductor provides a first electrode for the capacitor. A dielectric is disposed over the pitted surface of the semiconductor. A second electrode for the capacitor disposed over the dielectric.

In accordance with another feature of the invention, a DRAM cell is provided having a single crystal body. The body has formed therein a transistor and a capacitor coupled to the capacitor. The capacitor includes a doped single crystal semiconductor portion formed in the body, such portion having a pitted surface. The doped semiconductor portion provides a first electrode for the capacitor. A dielectric is disposed over the pitted surface of the semiconductor. A second electrode for the capacitor is disposed over the dielectric and electrically is connected to the transistor.

In accordance with another feature of the invention, a method for processing a semiconductor is provided. The method includes the steps of providing the semiconductor; subjecting the semiconductor to heat and pressure producing pits in a surface of the semiconductor; and rounding the pits produced in the surface of the semiconductor.

In accordance with another feature of the invention, the steps of subjecting the semiconductor to heat and pressure producing pits in a surface of the semiconductor and rounding the pits produced in the surface of the semiconductor are performed in a common apparatus.

In accordance with another feature of the invention, a dielectric layer is deposited on the semiconductor surface prior to the step of the subjecting the semiconductor to heat and pressure producing pits in a surface of the semiconductor.

In accordance with another feature of the invention, the step of subjecting the semiconductor to heat and pressure producing pits in a surface of the semiconductor comprises the step of subjecting the semiconductor with the dielectric layer thereon to a first anneal and wherein the step of rounding the pits produced in the surface of the semiconductor comprises the step of subjecting the semiconductor to a second anneal.

In accordance with another feature of the invention, the first anneal comprises the step of subjecting the semiconductor to a first temperature and a first pressure and the second step anneal comprises the step of subjecting the semiconductor to a second anneal, the second temperature being higher than the first temperature.

In accordance with another feature of the invention either: (A) the first pressure is higher than the second pressure; or, (B) the second temperature is higher than the first temperature and the first pressure is higher than the second pressure; or, the second temperature is greater than the first temperature and the second pressure is equal to the first pressure.

### Brief Description of the Drawing

Other features of the invention, as well as the invention itself, will become more readily apparent from the following detailed description taken together with the accompanying drawings, in which:
FIGS. 1A-1E are cross-sectional diagrammatical sketches of a trench-capacitor DRAM cell at various stages in the fabrication thereof in accordance with the invention;
FIG. 2 is are curves showing the relationship between etch rate and temperature as reported in the PRIOR ART;
FIG. 3 is a series of sketches showing the effect of etching silicon dioxide on silicon at two different temperatures as reported in the PRIOR ART;
FIGS. 4A and 4B are temperature and pressure profiles used during a pair of sequential anneal steps used in producing the DRAM of FIGS. 1A - 1E according to the invention;
FIGS. 5A-5D are cross-sectional diagrammatical sketches of a capacitor used in the DRAM cell of FIGS. 1A-1E at various stages in the fabrication thereof in accordance with the invention;
FIGS. 6A and 6B are temperature and pressure profiles used during a pair of sequential anneal steps used in producing the DRAM of FIGS. 1A - 1E according to the invention; and
FIGS. 7A-7D are cross-sectional diagrammatical sketches a stack-capacitor DRAM cell at various stages in the fabrication thereof in accordance with the invention, FIG. 7B being an enlarged portion of FIG. 7A, such enlarged portion being circled and labelled 7B-7B in FIG. 7A.

### Detailed Description

The invention relates to the formation of a capacitor used in an integrated circuit (IC). Such IC is, for example, a random access memory (RAM) including a dynamic random access memory (DRAM) or a synchronous DRAM (SDRAM). Other ICₛ, such as an application specific IC (ASIC) or a merged DRAM-logic circuit (embedded DRAM) are also useful.

Typically, numerous ICs are formed on the wafer in parallel. After processing is finished, the wafer is diced to separate the ICs to individual chips. The chips are then packaged, resulting in a final product that is used in, for example, consumer products such as computer systems, cellular phones, personal digital assistants (PDAs), and other electronic products.

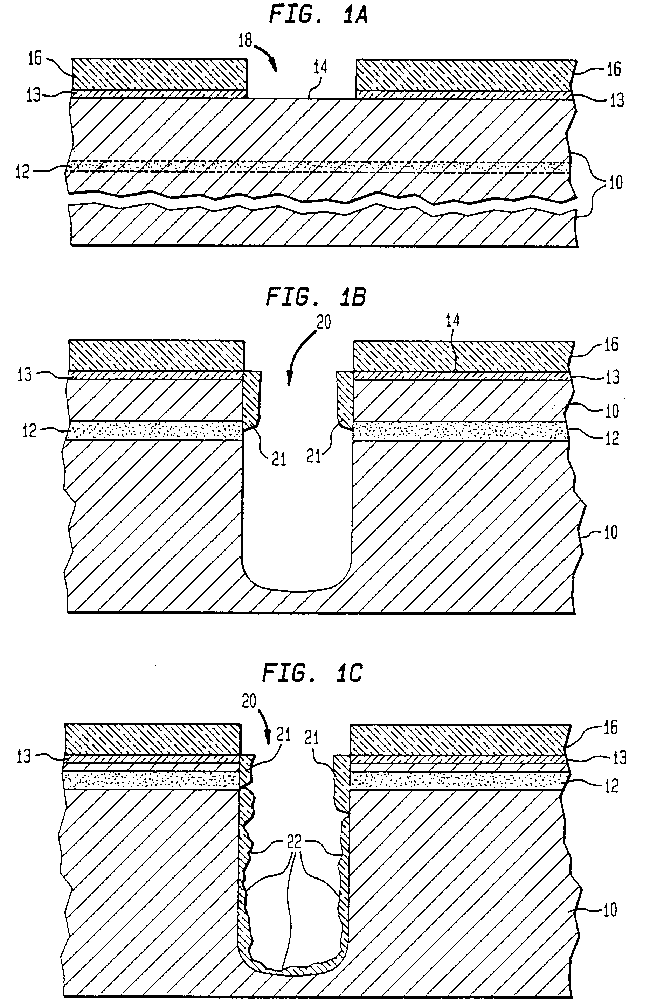

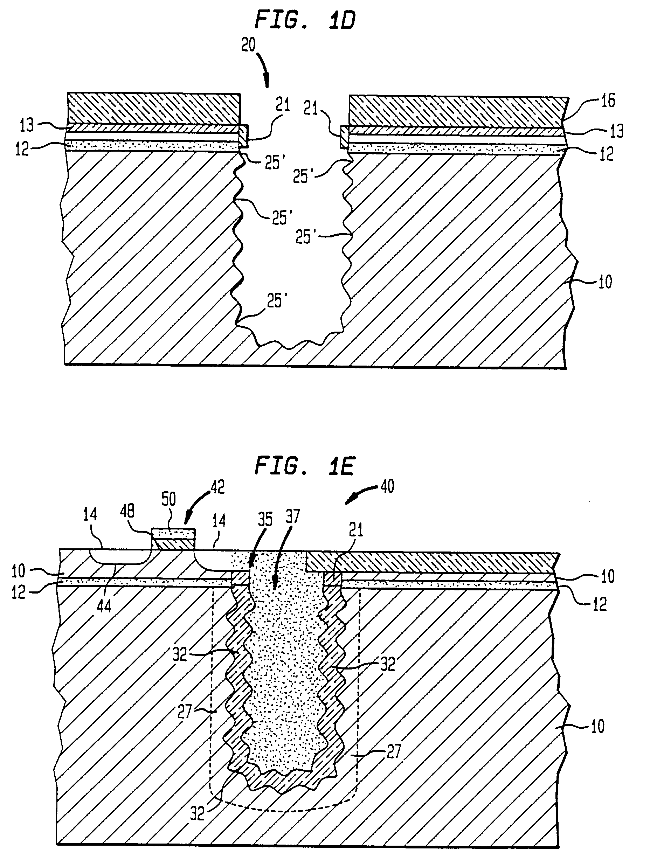

Referring to FIG. 1, a cross-section of a protion of substrate, such as a silicon wafer, is provided. Other substrates, such as gallium arsenide, germanium, or other semiconductor material, are also useful. The substrate, for example, may be lightly or heavily doped with dopants of a pre-determined conductivity to achieve the desired electrical characteristics. As shown, a buried ion implanted layer 12, here phosphorous is formed therein at a depth of here 1.5 microns from the upper surface 14 of the silicon substrate 10. The doping concentration of the buried doped layer 12 here has a dosage of about 10¹² to 10¹⁴ per cm². A pad layer 13 of silicon dioxide, here about 100 Angstroms thick, is thermally grown over the upper surface 14 of the silicon substrate 10. A dielectric layer 16, here a 1000 to 5000 Angstroms thick layer of silicon nitride and/or silicon dioxide is disposed on the upper surface of the silicon dioxide pad layer 13, as shown.

Subsequently, as shown in FIG. 1A, a window 18 formed is formed in the silicon nitride layer 16 using conventional photolithographic (i.e., a hard TEOS or BSG mask, not shown) and chemical etching (i.e., reactive ion etching (R.I.E.) techniques. The windowed silicon nitride layer 16 and hard mask are used as a mask to etch a trench 20 into an underlying portion of the upper surface 14 of the silicon substrate 10 using conventional etching techniques. Here, the depth of the trench 20 is in the order of 8 microns from the upper surface 14 of the silicon substrate 10, and the width of the trench 20 may be in the order of 0.10 microns to one-quarter micron. Here, a dielectric collar 21, (FIG. 1B), here deposited silicon dioxide having a thickness of 100-1000 Angstroms(Å), is formed around the upper portion of the trench 20 using any two-step trench etching process.

Next, an uneven dielectric layer 22 is formed on the surface of the trench 20, as shown in FIG. 1C. Here, the dielectric layer 22 is silicon dioxide which is thermally grown to about 10-30A. The thin silicon dioxide layer 22 may be a native silicon oxide grown in clean room air, thermal silicon dioxide, TEOS or nitride, for example. It is noted that the dielectric layer 22 has variations (i.e., non-uniformies) in its thickness and/or composition as well as local defects. Thus, as shown in FIG. 1C, the thickness of the dielectric layer 22 is uneven, i.e., has hills and valleys. It is noted that the non-uniformity in the layer 22 may be provided by other defects, such as low energy dopant.

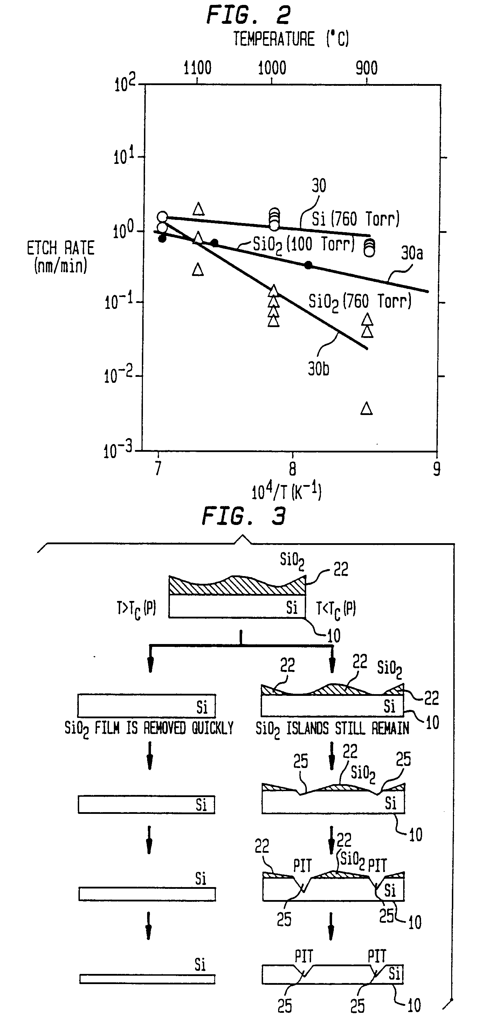

Referring briefly to FIG. 2, curves 30, 30a and 30b show the etch rate of silicon and silicon dioxide as a function of temperature; the curve 30 shows the etch rate for silicon at a pressure of about 760 Torr, curve 30a shows the etch rate for silicon dioxide at a pressure of about 100 Torr, and curve 30b shows the etch rate for silicon dioxide at a pressure of about 760 Torr. The curves 30, 30a, 30b are representative of a hydrogen ambient. It is noted that above a critical temperature, T_{c}(p), is a function of pressure, p, the etch rate of silicon dioxide (i.e., curves 30a, 30b) in the hydrogen ambient is lower than the etch rate of silicon; whether single crystalline silicon, polycrystalline silicon, or amorphous silicon. The relationship between etch rate and temperature at 760 Torr has been reported in an article entitled "Roughness of Silicon Surface Heated in Hydrogen Ambient" by Habuka, et al, published in the Journal of the Electrochemical Society, vol. 142, No. 9, September 1995.

The non-uniformities (i.e., thickness, low energy dopant or other defects) in the silicon dioxide layer 22 (FIG. 1C) lead to spots where punch-through of the silicon dioxide occurs, while other locations are still covered with the silicon dioxide. Thus, referring to FIG. 3 reported in the above-identified article entitled "Roughness of Silicon Surface Heated in Hydrogen Ambient" by Habuka, et al, a layer 22 of silicon dioxide is shown disposed on a layer of silicon 10. The left side of FIG. 3 shows etching at a temperature above the critical temperature T_{c}(p) and the right side of FIG. 3 shows etching at a temperature below the critical temperature T_{c}(p). It is noted that at the temperature greater than the critical temperature, t_{c}(p), the silicon dioxide film 22 is removed quickly resulting in a relatively smooth surface of silicon 10 after the layer 22 has been removed. However, when etching is at a temperature below the critical temperature t_{c}(p), pits 25 are formed in the silicon layer 10. Thus, below the certain critical temperature, T_{c}(p) where the etch rate for silicon is significantly higher that of silicon dioxide, the higher etch rates of silicon compared to silicon dioxide result in pits 25 being formed in the silicon 10. From the curves in FIG. 2, it is noted that, for atmospheric pressure, the critical temperature is about 1000°C. For atmospheric pressure, at temperatures greater than the critical temperature, T_{c}(p) the etch rate difference is small and the silicon dioxide film is removed quickly. FIG. 2, shows that at, for example, about 100 Torr, the temperature dependence of the silicon dioxide etch rate in hydrogen is less pronounced and the etch rates at lower temperatures are closer to that of silicon in hydrogen, which shows little temperature dependence. Thus, at lower pressure, the critical temperature, T_{c}(p) will be lower than that at higher pressure.

Thus, referring to FIG. 1C, after the dielectric layer of silicon dioxide 22 is grown over the silicon 10, the structure is placed in a chamber or furnace, not shown. A two-step anneal process is then performed. During the first step, the non-uniformities, (i.e., hills and valleys, low energy dopant, or defects, for example) of the silicon dioxide layer 22 are transferred into the pits 25 (FIG. 3) formed on the sidewalls and bottom of the trench 20 and, during the second anneal sharp edges of the pits 25 are rounded to pits 25'. It is first noted that the formation of, and rounding of, the pits 25 may be produced in the hydrogen ambient, as mentioned above, or in other inert, oxygen-free ambient, such as argon, helium and nitrogen, or an ultra-high vacuum anneal, for example. It is also noted that the two anneals are performed in the same chamber, i.e., in situ, and the resulting structure is shown in FIG. 1D.

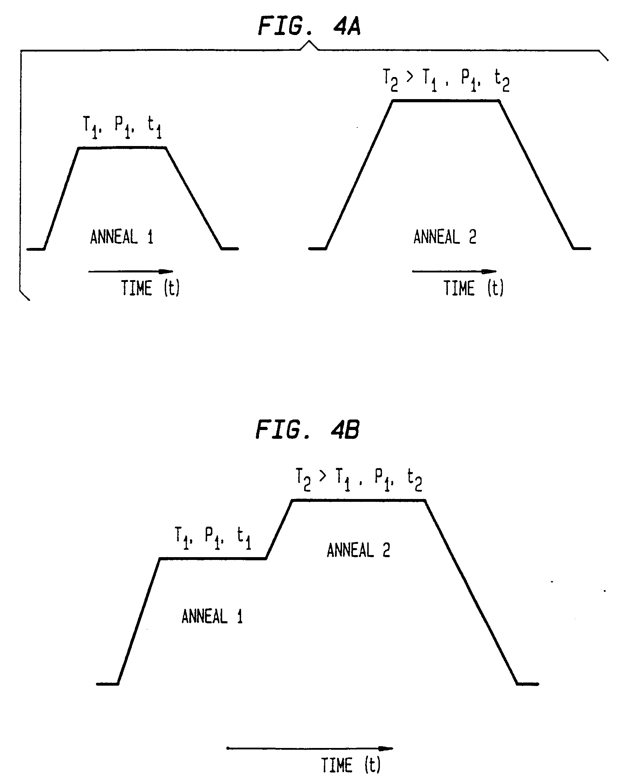

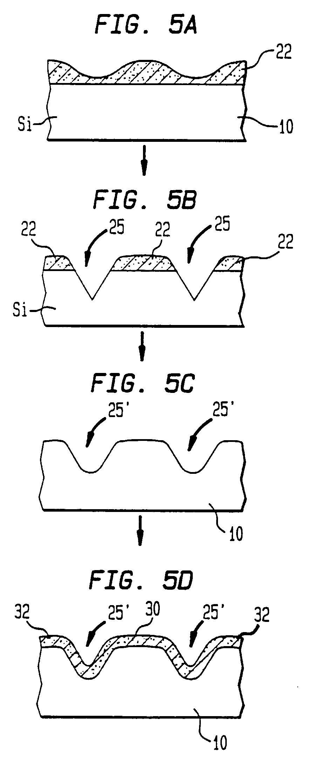

Thus, referring also to FIGS. 5A-5D, after the uneven silicon dioxide layer 22 is formed, the structure is placed in a chamber for the anneal processing. During the first anneal step (FIG. 5B), the chamber is at a first relatively low temperature, T₁, (i.e., lower than the critical temperature T_{c}(p)) as shown in the left side of FIG. 4A to thereby form the pits 25, described in connection with FIG. 3 and shown again in FIG. 5B. During the next anneal, in situ, the temperature is increased to a temperature T₂, as shown in the right side of FIG. 4A, to round sharp edges of the pits 25 and thereby form rounded pits 25', as shown in FIG. 5C and also to remove any remaining silicon dioxide layer 22. If only partial removal of the remaining silicon dioxide can be achieved, a wet etch step, e.g., dilute or buffered hydrofluoric acid can be used. FIG. 4B shows the two sequential anneal steps. The pits 25 are rounded to pits 25' by surface migration of silicon atoms during the second anneal step.

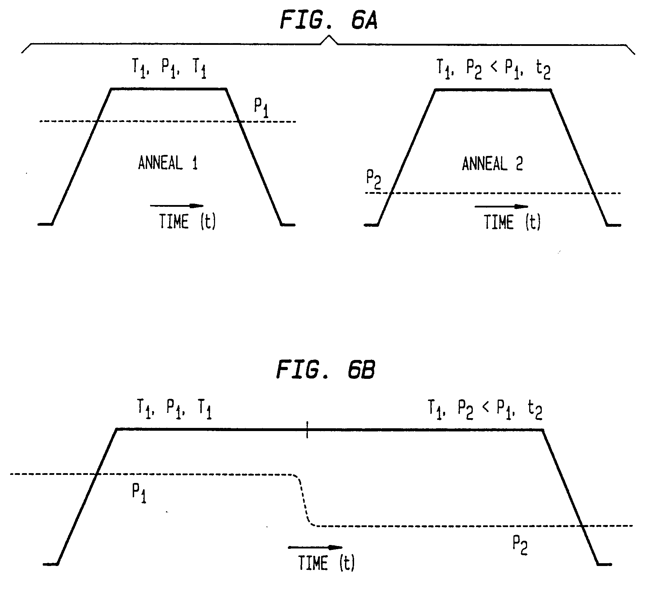

It should be noted that the two-step anneal may be performed with the temperature remaining constant for both anneal steps with the pressure in the chamber being reduced in the second anneal step, as shown in FIGS. 6A and 6B. It should be noted that during the first anneal step, for the first pressure, p₁, the temperature T₁, is below the critical temperature T_{c}(p) for pressure, p₁, and for the second anneal step, where the pressure is p₂, the temperature T₂ is higher than the critical temperature, T_{c}(p) for pressure p₂. Thus, as shown in FIG. 6B the temperature is constant for both anneal steps; during the first anneal step the structure is above a critical pressure and using the second anneal step the structure is below the critical pressure.

In one embodiment, the first anneal, (i.e., pit 25 formation (FIG. 5B)) is performed at a temperature, T₁, of about 850°C for about 10 to 60 minutes at a pressure p₁ of about 20 Torr and with hydrogen at a rate of 2 standard liters per minute. The second, in situ, anneal is performed (i.e., pit 25 rounding to pit 25' and silicon dioxide layer 22 removal) by processing in situ as follows: at a temperature T₂ of about 950°C to 1000°C at a pressure, p₂, of about 1 Torr and a flow of hydrogen of 2 standard liters per minute. The depths of the pits are here typically several to ten nanometers.

Next, after the pits 25 have been rounded to pits 25', as shown in FIGS. 1D and 5C, arsenic or phosphorus is diffused into the pitted sidewalls and bottom walls of the trench to formed a doped region 27. This doped region 27 provides one electrode, or plate, of a capacitor 35. Here, the doped region 27 is formed by elevating the temperature in the chamber to in the order of about 1000°C using arsine or phosphine gas. This may be performed, in situ, after the second anneal step, or it may be performed in a separate tool. Doping may also be performed in a separate tool by other methods such as ion implantation, plasma doping (PLAD), or plasma immersion ion implantation (PII).

Next, the capacitor 35 dielectric layer 32 is formed. Here, the structure is placed in a chamber at a temperature of about 800°C to 1000°C for about 30 minutes with ammonia (NH₃) at about 6 Torr; then with low pressure chemical vapor deposition (LPCVD) nitride formation at about 700°C in SiH₂Cl₂ (DCS) and NH₃; and then a thermally grown oxide at a temperature of about 900°C for 10 minutes at a pressure of about 760 Torr in H₂0 (i.e., reoxidation of the nitride).

Thus, two-step anneal, first electrode doped region 27, and dielectric layer 32 (FIG. 5D) may be performed sequentially in the same chamber or in a cluster tool. It is noted that the dielectric layer 32 has an irregular surface which conforms to the rounded pits 25' in the surface of the silicon 10. Thus, the surface area on the outer surface of the silicon dioxide layer 22 is greater than that which have resulted from merely depositing the silicon dioxide layer 22 on the trench 20 in FIG. 1B.

The structure is then processed in any conventional manner to form a DRAM cell 40, such as that shown in FIG. 1E. Thus, the capacitor 35 includes doped amorphous or doped polycrystalline silicon 37 on the dielectric layer 32 to form the second electrode of capacitor 35. It should be noted that the polycrystalline silicon or amorphous silicon deposition may be performed in situ. However, all these processes may be performed ex situ in separate tools, without departing form the scope of the invention. It is noted that the surface area of the second electrode 37 has been increased by the pits 25' in the surface of the silicon 10. The DRAM 40 includes a transistor 42, having source and drain regions 44, 46 separated by a gate channel 49. The gate channel 49 has disposed above it a gate oxide 48 and a doped polycrystalline silicon, or polycrystalline silicon-tungsten silicide gate electrode 50. It is noted that the drain region 46 is electrically connected to the doped polycrystalline silicon 37 to thereby electrically interconnect the drain region to the second electrode of capacitor 25.

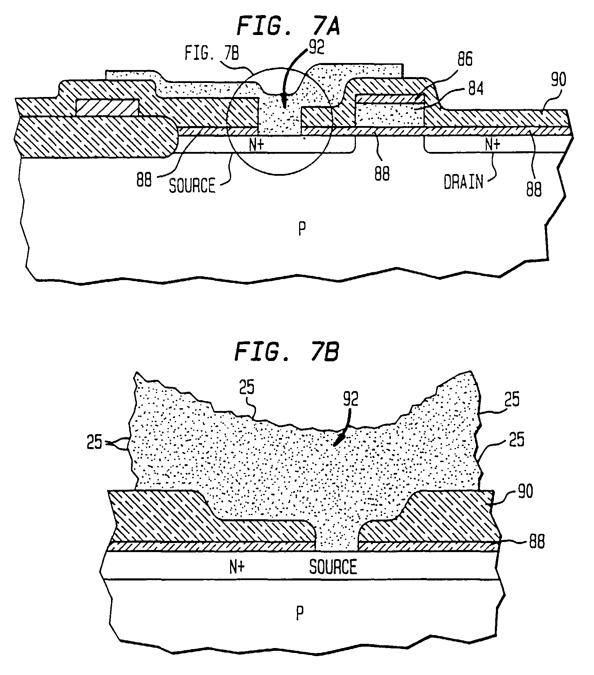

Referring now to FIGS. 7A-7D, a stack capacitor DRAM cell 80 is shown in FIG. 7D. A transistor 82 is formed in any conventional manner having a doped polycrystalline silicon layer 84 on a thermally grown oxide layer 88 and a conductor 86 on the doped polycrystalline silicon layer 86 to provide a gate electrode for the transistor 82. The transistor 82 has source and drain regions as indicated. After completing the formation of the transistor 82, the device is passivated with dielectric layer 90, in any conventional manner, as shown. Next, a lower conductor 92 for the stack capacitor 83 is formed in contact with the source region. The lower conductor 92 is doped silicon.

The structure, shown in FIG. 7A, is then processed using the two step anneal process described above in connection with FIGS. 1B-1E. Thus, an uneven dielectric layer, not shown is formed on the surface of the silicon conductor 92. After the dielectric layer, not shown, of silicon dioxide is grown over the silicon conductor 92 the structure is placed in a chamber or furnace, not shown. The two-step anneal process described above, is then performed. During the first step, the non-uniformities, (i.e., hills and valleys, low energy dopant, or defects, for example) of the silicon dioxide layer are transferred into the pits 25 (FIG. 7B) formed on the sidewalls and top of the conductor 92 (i.e., the bottom plate of the stack capacitor 83) and, during the second anneal sharp edges of the pits 25 are rounded.

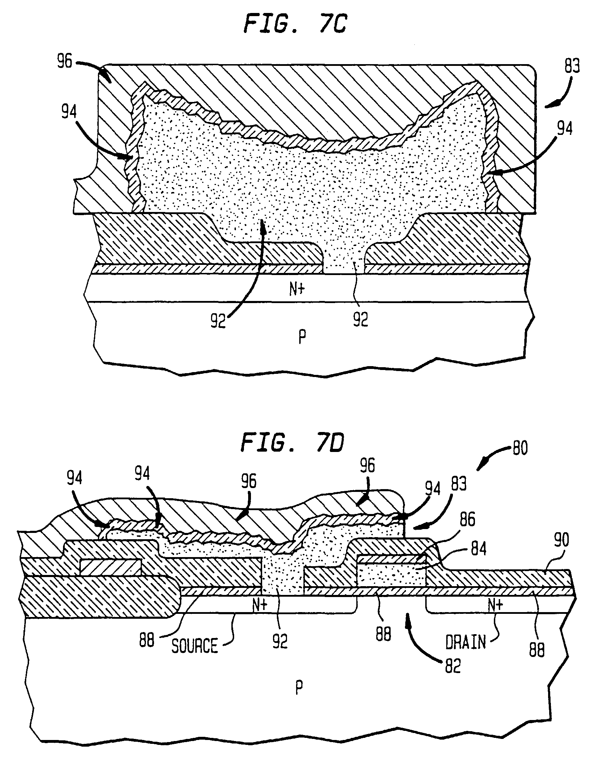

Next, a dielectric layer 94 is deposited over the processed silicon conductor 92 and a conductor 96 (i.e., the top electrode of capacitor 83) is formed over the dielectric layer 94 (FIG. 7C). It is noted that the surface area of the conductors 92 and 96 and the capacitor dielectric 94 of the capacitor 83 is greater than that which have resulted not pitting the silicon conductor 92 in FIG. 7A. Thus, the capacitance of capacitor 83 is increased.

While the invention has been particularly shown and described with reference to various embodiments, it will be recognized by those skilled in the art that modifications and changes may be made to the present invention without departing from the scope thereof. The scope of the invention should therefore be determined not with reference to the above description but with reference to the appended claims along with their full scope of equivalents.

## Claims

1. A method for processing a semiconductor, comprising the steps of:
providing the semiconductor;
subjecting the semiconductor to heat and pressure producing pits in a surface of the semiconductor; and
rounding the pits produced in the surface of the semiconductor.

2. The method recited in claim 1 wherein the providing step includes the step of providing a silicon semiconductor.

3. The method recited in step 2 wherein the providing step includes the step of providing single crystal silicon.

4. The method recited in step 2 wherein the providing step includes the step of providing polycrystalline silicon.

5. The method recited in step 2 wherein the providing step includes the step of providing amorphous silicon.

6. The method recited in claims 1, 2, 3, 4 or 5 wherein the steps of subjecting the semiconductor to heat and pressure producing pits in a surface of the semiconductor and rounding the pits produced in the surface of the semiconductor are performed in a common apparatus.

7. The method recited in claim 6 including the step of forming a dielectric layer on the semiconductor surface prior to the step of the subjecting the semiconductor to heat and pressure producing pits in a surface of the semiconductor.

8. The method recited in claim 7 wherein the step of subjecting the semiconductor to heat and pressure producing pits in a surface of the semiconductor comprises the step of subjecting the semiconductor with the dielectric layer thereon to a first anneal and wherein the step of rounding the pits produced in the surface of the semiconductor comprises the step of subjecting the semiconductor to a second anneal.

9. The method recited in claim 8 wherein the first anneal comprises the step of subjecting the semiconductor to a first temperature and a first pressure and the second step anneal comprises the step of subjecting the semiconductor to a second anneal, the second temperature being higher than the first temperature.

10. The method recited in claim 8 wherein the first pressure is higher than the second pressure.

11. The method recited in claim 8 wherein the first temperature is lower than the second temperature.

12. The method recited in claim 9 wherein the second temperature is higher than the first temperature and the first pressure is higher than the second pressure.

13. The method recited in claim 12 wherein the insulating layer comprises silicon dioxide.

14. The method recited in claim 13 wherein the first temperature is about 850°C, the second temperature is about 950-1000°C, the first pressure is about 20 Torr and the second pressure is about 1 Torr.

15. A method for forming a dielectric for a capacitor comprising the steps of:
providing a semiconductor;
forming a non-uniform layer on a surface of the semiconductor;
subjecting the semiconductor and the non-uniform layer thereon to heat and pressure producing pits in a surface of the semiconductor;
forming a second dielectric over the pitted surface of the semiconductor to provide the dielectric for the capacitor.

16. The method recited in claim 15 wherein the providing step includes the step of providing a silicon semiconductor.

17. The method recited in step 15 wherein the providing step includes the step of providing single crystal silicon.

18. The method recited in step 15 wherein the providing step includes the step of providing polycrystalline silicon.

19. The method recited in step 15 wherein the providing step includes the step of providing amorphous silicon.

20. The method recited in claims 13, 14, 15, 16 or 17 wherein the step of subjecting the semiconductor to heat and pressure producing pits in a surface of the semiconductor comprises the step of subjecting the semiconductor with the non-uniform layer thereon to a first anneal and wherein the step of rounding the pits produced in the surface of the semiconductor comprises the step of subjecting the semiconductor to a second anneal.

21. The method recited in claim 20 wherein the first anneal comprises the step of subjecting the semiconductor to a first temperature and a first pressure and the second step anneal comprises the step of subjecting the semiconductor to a second anneal, the second temperature being higher than the first temperature.

22. The method recited in claim 21 wherein the first pressure is higher than the second pressure.

23. The method recited in claim 22 wherein the second temperature is higher than the first temperature and the first pressure is higher than the second pressure.

24. The method recited in claim 23 wherein the non-uniform layer comprises silicon dioxide.

25. The method recited in claim 24 wherein the first temperature is about 850 °C, the second temperature is about 950-1000°C, the first pressure is about 20 Torr and the second pressure is about 1 Torr.

26. A capacitor, comprising:
a doped single crystal semiconductor having a pitted surface, such doped semiconductor providing a first electrode for the capacitor;
a dielectric disposed over the pitted surface of the semiconductor;
a second electrode for the capacitor disposed over the dielectric.

27. A DRAM cell, comprising:
a single crystal body having formed therein:
(a) a transistor; and
(b) a capacitor coupled to the transistor, such capacitor comprising:
(i) a doped single crystal semiconductor portion formed in the body, such portion having a pitted surface, such doped semiconductor portion providing a first electrode for the capacitor;
(ii) a dielectric disposed over the pitted surface of the semiconductor;
(iii) a second electrode for the capacitor disposed over the dielectric and electrically connected to the transistor.

28. The method recited in claim 8 wherein the subjecting step includes the step of using a hydrogen ambient.

29. The method recited in claim 8 wherein the subjecting step includes the step of using an oxygen-free ambient.

30. The method recited in claim 29 wherein the ambient is an inert gas.
